# EUROPEAN PATENT APPLICATION

(11) **EP 4 579 248 A1**
(43) Date of publication of application: **02.07.2025**
(21) Application number: 23220731.6
(22) Date of filing: 29.12.2023
(51) Int. Cl.: G01R 15/20

(54) **CURRENT SENSOR FOR MONITORING ELECTRICAL SYSTEMS**

(71) Applicant: Melexis Technologies SA, 2022 Bevaix (CH)
(72) Inventor: BOURY, Bruno, 3980 Tessenderlo (BE); GALLOT, Mathieu, 2022 Bevaix (CH)
(74) Representative: Winger

(57) **Abstract**

A current-sensing system for fault detection includes a sensing element for detecting a magnetic field and a magnetic core that encloses at least two target conductors. The sensing element is mechanically uncoupled from the magnetic core, and it is designed to detect a component of the magnetic field superposition by currents in the target conductors, the field being generated inside the core and traversing an opening in the core. The sensing element provides an output signal indicative of this superposition. The system is able to detect the combined magnetic field effects of multiple currents, enabling accurate fault detection in electrical systems.

## Description

### Field of the invention

The present invention relates to current-sensing systems for fault detection electrical systems, particularly to a system that includes a magnetic sensor.

### Background of the invention

The field of electrical current sensing is a critical aspect of modern electrical systems, encompassing a wide range of applications from industrial automation to consumer electronics including accumulation or energy conversion. Current sensors are important for monitoring the flow of electricity and ensuring the safety, efficiency, and reliability of electrical circuits. They are used to detect overcurrent conditions, measure power consumption, and identify faults within electrical systems.

In polyphase electrical systems, such as those found in industrial settings, the ability to monitor multiple phases of current simultaneously is particularly important. These systems often employ multiple conductors carrying currents that may be phase-shifted with respect to each other. The accurate detection and monitoring of these currents are vital for system control and fault detection.

A common problem in the field is the detection of faults such as ground faults or short circuits within a polyphase system. Faults can lead to serious consequences, including equipment damage, system downtime, and safety hazards. Therefore, it is crucial to detect such faults promptly and accurately to initiate protective measures.

Another challenge in the field is the design of current sensors that can operate effectively within the confines of a compact and densely packed electrical environment. This integration presents its own set of challenges, such as ensuring accurate sensing despite the close proximity of conductors and managing the effects of electromagnetic interference.

Existing devices include wound coils around cores. These systems are expensive, bulky and for a high sensitivity, the complexity of the manufacture is high, since a large number of windings and accurate assembly is required.

Despite the advancements in current sensing technology, there remains a need for further improvements in the field. The industry continues to seek solutions that can provide accurate, reliable, and efficient current sensing capabilities to meet the evolving demands of modern electrical systems.

### Summary of the invention

It is an object of embodiments of the present invention to provide a current sensing system for detecting fault, such as leak, in multiple conductors, with a simple layout, accuracy and mechanical robustness.

The present inventio provides in an aspect a current-sensing system for fault detection comprising a sensing element for detecting magnetic field and a magnetic core with an opening. The magnetic core is arranged for enclosing at least two target conductors, and the sensing element is configured for detecting a component of the superposition of the magnetic field generated through the opening by at least two currents carried by the respective target conductor. The sensing element is mechanically uncoupled from the magnetic core. Further, the sensing element is configured to provide an output signal indicative of the superposition of the magnetic field.

It is an advantage of embodiments of the present invention that a compact, accurate and fast monitoring device for polyphase electrical systems can be provided. It is a further advantage that the robustness is improved, as well as thermal and lifetime drift.

In some embodiments, the sensing element is at least 0.5 mm away from the magnetic core.

It is an advantage of embodiments of the present invention that a mechanically robust system can be obtained, by avoiding contact between the sensing element, or sensor package including it, and the core.

In some embodiments, the system further comprises a substrate comprising at least two target conductors being conductive traces.

It is an advantage of embodiments of the present invention that the target conductors can be provided in a single PCB, facilitating setup and alignment.

In some embodiments, the width-to-thickness ratio of the traces is at least 10, for example at least 100.

It is an advantage of embodiments of the present invention that a very compact system can be provided.

In particular, the conductive traces are stacked on top of each other in the substrate.

It is an advantage of embodiments of the present invention that the conversion factor is low. The traces may be embedded in the substrate.

In some embodiments, a first trace in the stack is located closest to the sensing element, wherein a second trace is the stacked conductive trace located in the stack so that the first trace is present between said second trace and the sensing element. A first current-to-magnetic field conversion factor from the first trace is less than 5%, or less than 2%, or less than 1% different than a second current-to-magnetic field conversion factor from the second trace.

It is an advantage of embodiments of the present invention that the precise fault detection can be achieved. It is a further advantage that in embodiments where the superposition is 0, fault can be detected more reliably since the conversion factor is small.

In particular embodiments, the sensing element is provided on a sensor on the substrate comprising the at least two target conductors. For example, the sensor may be connected to the substrate containing or embedding the traces.

It is an advantage that a highly compact device can be obtained.

In some embodiments, at least one target conductor loops so that the current of said conductor is enclosed at least twice by the magnetic core.

It is an advantage of embodiments of the present invention that the conversion factor is low. The traces may be embedded in the substrate.

In some embodiments, the number of conductors is 2 or larger, for example between 3 and 5.

It is an advantage of embodiments of the present invention that a ground fault in a multiphase current can be detected.

In some embodiments, the sensing element is provided on a planar sensor substrate comprising at least one largest dimension. The at least one largest dimension of the sensor substrate is smaller than the width of the opening in the yoke.

It is an advantage that the system has a more compact assembly. It is a further advantage that it has a low sensitivity to mechanical displacements.

In some embodiments, the sensing element is sensitive to a component of the magnetic field in one direction.

It is an advantage of embodiments of the present invention that no magnetic concentrators are required, thus reducing cross talk from target conductors.

In some embodiments, the sensing element is provided on a sensor substrate comprising at least one planar surface on a side, wherein the magnetic sensing element comprises an axis of maximum sensitivity parallel to the plane of the largest surface of the sensor substrate, wherein the opening is provided on the magnetic core such that the magnetic field across the opening is parallel to the axis of maximum sensitivity of the sensing element.

It is an advantage that the assembly is simple since the sensor including the sensing element may be positioned next to the opening.

In some embodiments, the sensing element is provided on a planar sensor substrate comprising at least one largest surface, wherein the magnetic sensing element comprises an axis of maximum sensitivity perpendicular to the plane of the largest surface of the sensor substrate. The opening is provided on the magnetic core such that the magnetic field across the opening is parallel to the axis of maximum sensitivity of the at least one sensing element.

It is an advantage that the detected signal is high compared to other dispositions. The signal to noise ration may also be higher.

In some embodiments, the system further comprises a processing circuit configured to detect fault based on the superposition signal.

It is an advantage of embodiments of the present invention that the accuracy can be adjusted by programming different conditions for fault detection.

In particular, the processing circuit is configured to detect fault upon detection of a field surpassing a threshold value.

It is an advantage that the fault can be detected if the sum is different from 0 within a threshold, since in a balanced system the sum of the fields will be null.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 is a cross-sectional view of a current-sensing system with a magnetic core enclosing a stack of conductive traces on a PCB and a sensor with a sensing element detecting the magnetic field through an opening in the core, according to embodiments of the present invention.
FIG. 2 is a cross-sectional view of a current-sensing system with a magnetic core and a sensor with a sensing element detecting a perpendicular magnetic field component through an opening adjacent to a stack of conductive traces on a PCB, according to embodiments of the present invention.
FIG. 3 shows a perspective view of two magnetic cores with different configuration of opening, and different relative positioning of the opening relative to the target conductors.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings, but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

Where in embodiments of the present invention reference is made to "trace", reference is made to a type of conductor characterized by their shape. In particular a trace is a conductive metal sheet which carries electric signal. Usually, a conductor laid out on a substrate, and which carries a signal within the plane parallel to the surface of that substrate, are commonly known as trace. This is the case with particular printed circuit boards (PCBs). As shown below, a trace is usually a flat conductor with a first dimension through which the signal is carried between a source and a sink, a second dimension being the width, and a third dimension being the thickness. In a trace, the thickness is much lower than the width.

The present invention relates to current sensing, using an apparatus designed to monitor electrical currents for the purpose of identifying abnormal conditions or faults. This system includes components that are capable of detecting magnetic fields generated by electrical currents and interpreting those fields to identify potential faults.

For detecting current leaks, specialized circuits such as residual current devices (RDCs), including ground fault circuit interrupters (GFCIs), can be used. These usually disconnect the electric energy if there is a loss to ground within 1/40 of a second or even faster. Existing RDCs include coils wound around cores, with two conductors which, if not balanced, generate a magnetic flux on the core, inducing a current which can be detected. The detection of a current implies the imbalance of current between the conductors, indicating a leak.

The present invention provides a simplified and robust current-sensing system for fault detection which can be used as electrical circuit breakers, power supply units, or any other electrical system where monitoring of current for safety or operational integrity is required. For example, the present invention can be implemented as RDC, for example as a GFCI. These devices include a sensor which generates a readable signal when an electromagnetic field is detected. In some embodiments, for example, the system may be implemented so that an electromagnetic field is generated when a fault, e.g. leakage, occurs between a plurality of conductors called 'target conductors' or TCs throughout the present text. Where there is no leak, the TCs generate a null electromagnetic field.

The present invention provides magnetic field detection. The TCs are arranged so that they generate a predetermined magnetic field by superposition. The superposition of the magnetic field generated by the TCs is detected by a magnetic sensing element which may be provided on a sensor. The superposition field is detected and can be compared with an expected signal, for example an expected value of a signal. The measurement of the superposition field, in particular the result of the comparison with the predetermined value or signal, is used to detect a fault, for example a leakage, e.g. caused by a ground fault.

As used therein, the term 'sensing element for detecting magnetic field' refers to a component or device within the current-sensing system that is specifically designed to sense or measure magnetic fields. This element converts the magnetic field information into an electrical signal that can be further processed. Examples of specific embodiments of sensing elements for detecting magnetic fields include Hall effect element, magnetoresistive elements, inductive coil elements, and fluxgate elements.

Where in embodiments of the present invention reference is made to 'sensor', reference is made to a die, or 'sensor substrate', including the sensing element and signal connections, usually known as 'leads'. The die may be a semiconductor die and it may be processed as an integrated circuit (IC). In some embodiments, the sensing element (or elements) are arranged on or in an active surface of the sensor substrate. The sensor substrate and sensing element may be molded, thus forming a sensor package that may be connected to a substrate such as a PCB.

In some embodiments of the present invention, the substrate which includes the TCs is also the substrate on which the sensor package is connected thus advantageously providing a compact current sensing system.

The TCs may carry different types of currents, for example a DC current, or alternate current, for example a multiphase current. A balanced 3-phase current, with 120-degree phase shift, is an example of such multiphase current. In a balanced 3 phase system (120-degree phase shift) the sum of current should be null, which is the expected signal. Thus, in a 3-phase system, the superposition is checked not to exceed 0 by a predetermined value. However, the present invention can be applied to other alternate currents (e.g. 2-phase current). In a two-phase, 90-degree phase shifted system, the superposition field results in a sine signal. A deviation of such behavior is picked by the magnetic sensor from the variations of the magnetic field. Other currents may be applied to the TCs, which generate by superposition a field.

The magnetic field around the TCs is captured by a magnetic core, commonly known as a 'yoke'. The magnetic core is arranged such that it surrounds or encompasses two or more conductors through which electrical current flows. This configuration allows the magnetic fields from the individual TCs to interact within the core's opening. The conductors may be wrapped around the core.

Examples of specific embodiments of magnetic cores with an opening may include toroidal cores, E-cores, or C-cores, among others. The term 'magnetic core' or 'yoke' will be used indistinctly throughout the description and claims. The yoke in embodiments of the present invention encloses the TCs conductor. However, the yoke has an opening, so it does not surround the TCs for 360 degrees. In other words, the magnetic core is made of a magnetic material that is shaped to have a gap or aperture through which magnetic flux can pass, leaving the yoke, traversing a different material (e.g air) and entering again into the yoke. The magnetic core is used to concentrate and guide the magnetic field generated by electrical currents in the target conductors.

The opening provides a total separation or gap, which breaks the field loop. The magnetic field is forced to traverse the opening to close the loop. The magnetic sensing element senses the magnetic field through this opening. The opening could cover 25% of the outer perimeter of the yoke or less. For example, if the yoke is square, one of the sides of the squares would be removed, leaving a squared 'u' shape. The opening may cover for example between 0.5% and 20% of the perimeter, for example between 1% and 10% of the perimeter.

In embodiments of the present invention, the sensing element in the system of the present invention is mechanically uncoupled from the yoke. For example, the sensor including the sensing element does not mechanically contact the yoke, e.g. there is no mechanical contact between the sensor package and the yoke. This refers to the physical arrangement where the sensing element, or the sensor on which it is mounted, is not rigidly attached or directly mechanically connected to the magnetic core, allowing for independent movement or vibration without direct mechanical influence from the core. Examples of specific embodiments of being mechanically uncoupled include mounting the sensor on a separate substrate. A non-rigid coupling could be used, such as an adhesive with damping properties, spacers adapted to provide non-rigid coupling, or the like. The field is sensed through the opening by the sensing element, but it (or the sensor) is not attached to the yoke around the opening, or in general to the yoke. While this potentially could reduce the accuracy of positioning, it has been found that the mechanical robustness of the device increases. There is no stress due to attachment layers or the like between the yoke and the sensor, and thermal stress is also reduced. In other words, there is a gap such as an airgap between the sensing element, e.g. the sensor, and the yoke, and both sensor and yoke are uncoupled from each other. In embodiments, there may be at least 0.5 mm of airgap between the sensing element (e.g. the sensor containing the sensing element) and the magnetic core, for example at least 1 mm.

In some embodiments, the sensing element is mounted on a circuit substrate (such as a PCB or the like), for example the sensor containing the sensing element is connected to a substrate. The substrate may include also the TCs. The substrate may be in this case the base material upon which conductive pathways or lines, known as traces, are formed or deposited. These traces act as the target conductors for the current-sensing system. Examples of specific embodiments of substrates with conductive traces include printed circuit boards (PCBs), flexible circuits, or ceramic substrates with metallic traces. The PCB may also include additional traces for sensing signal processing and/or output. The sensor substrate may be provided directly on the substrate comprising the traces, for example it could be mounted directly on the substrate (e.g. PCB) and encapsulated, or even integrated inside the substrate of the TCs. In the embodiments shown in the figures, however, the sensor substrate is shown as packaged separately and then connected to the substrate that includes the TCs.

In some embodiments, the TCs are provided as a stack of traces in the substrate. The TCs are stacked on top of each other, which in reference to conductive traces indicates that multiple traces are layered vertically, one above the other, as opposed to being laid out side-by-side on the same plane. Examples of specific embodiments of stacked conductive traces include multilayer PCBs where traces are present on different layers of the board. Since the sensor and the traces are provided on a single substrate, e.g. on a PCB substrate, a very compact current sensing system is obtained.

The yoke partially encloses the substrate. The current through each TCs generates a corresponding field, and these fields combine in a superposition field through the yoke, which is monitored by the sensor. Although the presence of the traces with relatively high currents may have a thermal impact in the electronics of the sensor, the system is overall highly stable since there is no contact between the sensor and the yoke, so thermal stresses are negligible.

In a first aspect, the present invention relates to a current sensing system for monitoring electrical systems having multiple phases, for example 3-phase systems.

The current-sensing system for fault detection includes a sensing element for detecting magnetic fields and a magnetic core with an opening. The magnetic core is designed to enclose at least two TCs, and the sensing element is configured to detect a component of the superposition of the magnetic fields generated through the opening by the currents carried by the respective target conductors. The sensing element is mechanically uncoupled from the magnetic core. For example, the sensing element may be mounted on a sensor that is mechanically uncoupled from the magnetic core, providing an output signal indicative of the superposition of the magnetic fields. With 'mechanically uncoupled' it is meant that the sensor is detached from the core, and there is no direct contact therebetween. For example, the mechanical uncoupling allows relative motion between the sensing element and the yoke without affecting or straining one another. Any mechanical link between the sensing element and the yoke provides damping of motion between them.

In general, the sensing element (or package, or PCB containing it) is mechanically uncopuled from, e.g. not in direct contact with, the yoke in the close proximity of the sensing element, so that vibrations, shocks or the like are damped before there is any transmission between the sensing element and the yoke.

The present invention provides a compact, accurate and fast monitoring device for polyphase electrical systems (e.g. for detecting faults, such as ground faults). In particular, the present invention relates to a device capable of detecting ground faults in polyphase electrical systems. The current sensing system comprises a magnetic sensor disposed so as to detect field through an opening of a magnetic core configured to enclose a plurality of TCs.

In one embodiment, the sensing element is positioned at least 0.5 mm away from the magnetic core to prevent mechanical stress and potential damage. The system may also include a substrate with conductive traces acting as the target conductors, which simplifies the system design and assembly. The width-to-thickness ratio of these traces is at least 10, or even at least 100, enhancing the magnetic field detection sensitivity. These conductive traces may be stacked on top of each other for a compact design, and where the traces are stacked, the conversion factor is low. The traces may be embedded in the substrate.

The sensor may comprise a sensing element for providing sensing of the magnetic field in a single location. The sensing element may be any of a Hall element, a magneto-resistive element, etc. The sensor may also include an integrated circuit (IC) packaged by a mold compound. The IC may include an active portion with the sensing elements. The package may include conductive vias or pins for connecting to a substrate and provide an output signal representative of the value of the detected magnetic field. The IC may have a largest dimension (e.g. a length) which may be smaller than the width of the opening in the magnetic core. The sensor may be sensitive to a field component, either parallel or perpendicular to the main (largest) side of the package, thus providing sensing of either component of the field at that single spot. Detecting the field at a single location allows a simple configuration, and also a very compact design allowing the use of small sensor substrate (e.g. small IC), and a cost-effective component since only one sensing element may be required.

The system may comprise one or more magnetic concentrators (MCs). These elements redirect the magnetic field. A concentrator allows to use sensing elements with a maximum sensitivity in a given direction to be used with components in a different direction, by converting a field component in a different component. In some embodiments, the output signal is based on the signal from a sensing element which detects a field component in a single location, converted by a magnetic concentrator. In some embodiments, the concentrator is a piece of magnetic material integrated in the sensor substrate. Said MCs are called integrated magnetic concentrator (IMC), and they may be integrated in an IC.

The system may be adapted to detect faults based on the superposition signal. For example, a processing circuit may receive signals generated by the sensing element. The processing circuit processes the output signal from the sensing element, which represents the combined magnetic fields from multiple conductors, to identify deviations or anomalies indicative of a fault condition. Examples of specific embodiments of processing circuits include microcontrollers, digital signal processors (DSPs), or custom integrated circuits designed for fault analysis. The processing circuit may identify a fault when the measured magnetic field, as represented by the superposition signal, exceeds a predefined limit or threshold. This threshold is set to distinguish normal operating conditions from fault conditions. Examples of specific embodiments of fault detection include overcurrent protection, short-circuit detection, or ground fault interruption. The processing circuit may be external, integrated with the sensor, provided on the same PCB as the sensor and connected thereto by conductive lines, etc.

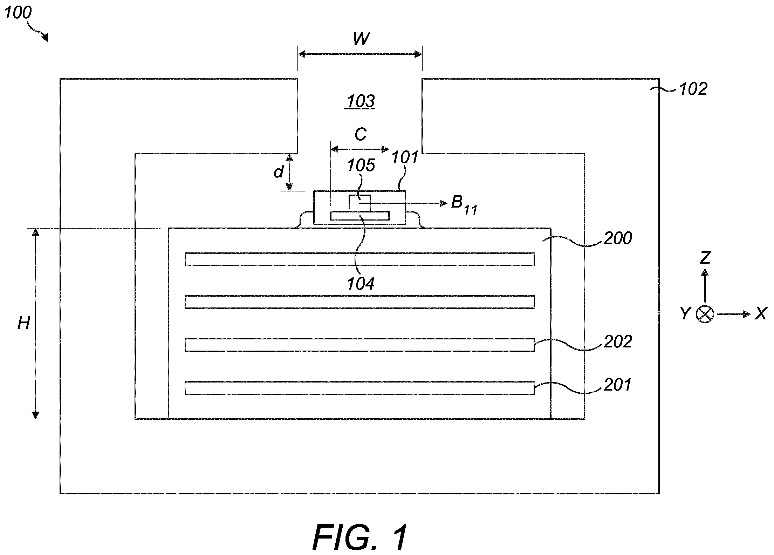

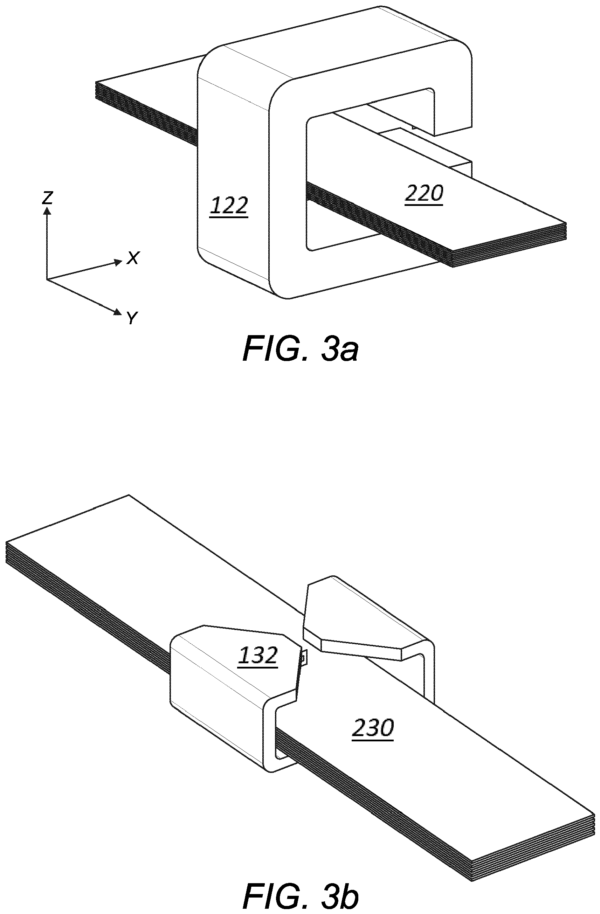

FIG 1 shows a cross-sectional view of a current-sensing system 100 in accordance with embodiments of the present invention, comprising a core and a sensor. The magnetic core 102 with an opening 103 encloses a stack of conductive traces 201, 202 within a printed circuit board (PCB). The sensor 101 with the sensing element 105 is strategically placed above the stack, and the opening in the magnetic core allows the magnetic field to pass through, where it is detected by the sensing element. In some embodiments, the sensor does not have IMCs, which reduces cross talk from target conductors and simplifies the assembly. The yoke may be a C-core or an R-shield, which differ in their shape as explained with reference to FIG 3 below.

The sensor can be provided on a substrate. For example, the sensor may be a packaged sensor with pins connected to the substrate. The package protects the IC and optionally any sensing element therein.

The IC of the sensor may be smaller than the width of the opening, so that the alignment is less sensitive to the exact position of the sensor, since the detected field changes in a smoother way when the opening is larger than the sensor. In some embodiments, the package of the sensor may be the same size or smaller than the opening.

The directions are defined, in the following, based on the direction Y of the current, the direction Z of the stack of the TCs, and the horizontal direction X perpendicular to the two first directions.

The sensor is sensitive to fields in the direction parallel to its surface, or the parallel component B₁₁. The sensor is oriented relative to the opening so that the parallel component is in the direction of the width of the opening in the horizontal direction X, so it coincides with the horizontal component Bx of the detected field.

The sensing element is preferably sensitive to a component of the magnetic field in one direction. The sensing element is designed to predominantly detect or measure the magnetic field strength along a specific spatial axis or orientation. This characteristic allows for targeted sensing of magnetic fields that align with the specified direction. Examples of specific embodiments of directionally sensitive sensing elements include elements based on magnetoresistance, e.g. anisotropic magnetoresistance (AMR) sensors, tunnel magnetoresistance (TMR) or Hall effect sensors with a defined sensing axis. Preferably, an axis of maximum sensitivity can be defined as the direction where the sensing element has the highest responsiveness or gain for detecting magnetic fields. In embodiments, the system is configured so that the sensing element has its axis of maximum sensitivity (B₁₁) in the direction X of maximum field through the opening. Where the sensing element comprises a Hall element, it may comprise at least one vertical Hall element (e.g. only one), and/or the combination of an IMC and at least one horizontal Hall element (e.g. only one).

In the particular case of FIG 1, the sensor is positioned by the opening, for example next to the opening. In some embodiments, the symmetry plane of the core passes through the sensor, in other words, the sensor is at the center of the core, and crossing the central plane of the opening. The inner surfaces of the core at the sides of the opening, facing the enclosed TCs, may form a plane across the opening. Said plane may be at a predetermined distance of the sensing element, for example at least 0.5 mm, for example at least 1 mm, so the sensor (e.g. the package) does not touch the yoke. The sensor may be provided on a substrate which includes inside the TCs, for example a PCB. Thus, the sensor may overlap the TCs. The TCs may be traces stacked in the vertical direction Z, perpendicular to both the horizontal direction X and the direction Y of the current. The TCs are at least 2, but it may be 3, 4, 5, or more. In other words, the number of conductors specifies the count of individual conductive paths or traces that are enclosed by the magnetic core and are part of the current-sensing system, and examples of specific embodiments of this term include systems with 2, 3, 4, or 5 separate conductive traces or wires that are monitored by the sensing element. This makes the system versatile for different electrical configurations

One or more TCs may include a loop so that the current of said conductor is enclosed at least twice by the magnetic core. A loop in this context refers to the physical layout of at least one target conductor such that its path forms one or more loops, resulting in the magnetic core enclosing the current path multiple times. This configuration can enhance the magnetic field interaction with the core. This allows improving fault detection sensitivity. Examples of specific embodiments of looping conductors include spiral or coiled conductors or traces that pass through the core's opening more than once.

In some embodiments, the substrate including the sensor and the TCs is part of the sensing system.

The system may have a configuration comprising 2 conductors through the yoke. For example, a conductor may carry a current with a phase and a conductor may be ground. When the currents are opposite, the total sum of currents is null, and the superposition of the fields is also null. The system may have a configuration comprising 3 conductors, with 3 phases. For example, in a balanced system, the phases are adapted so that the current through the yoke is null (the superposition field also being null). The system may have a configuration of 4 conductors, one of which is neutral, the other three carrying alternate currents with predetermined phases. The system may have a configuration of 5 conductors, one of which is neutral, another being ground, the other three carrying alternating currents with predetermined phases. The sum of currents through the conductors with alternating current may be null as explained earlier, and the currents in neutral and earth connection (ground) is also null. In normal operation, the superposition field is null, and in case of error the superposition will result in a magnetic field different from 0 over a threshold.

This is not the only possibility, as noted earlier; the expected superposition signal may be different from zero, so the system can be adapted to compare the measured signal with an expected, predetermined, signal (e.g. a known sinusoidal signal, for example).

The currents may flow in the substrate through the traces, each may carry approximately 30A RMS (root mean square), which means that the alternate current through the traces would be equivalent to a DC current of 30A for the same power dissipation through the conductor. The present invention may detect a deviation of the sum of all phases of at least 30mA, or at least 20mA, or at least 10 mA. Depending on the type and accuracy of the sensor, a difference of 30mA between the traces causes enough magnetic field through the yoke that it is detected by the sensor, and may generate an output signal of around 30mV. These particular values are only indicative, and the present invention may use different values. Triggering of action (such as shutdown of the current through the TCs) may take into account both the measured value and the period which said readings take. For example, the action may take place after a fraction of a second (e.g. one third of a second) passes while obtaining the reading corresponding to 30 or 35mA, while the action may be performed after a much shorter time (e.g. 40 milliseconds) passes during which a much higher current (e.g. 150mA) is measured.

As used herein, and unless otherwise specified, the term "current-to-magnetic field conversion factor" refers to the proportionality constant or coefficient that relates the electrical current flowing through a conductor to the magnetic field it produces.

Surprisingly, it has been found that in embodiments of the present invention, the conversion factor from current to field for each trace at the sensor location are very similar. For example, a difference in the conversion factor of less than 5%, 2%, or 1% between two traces has been found, which indicates a high degree of similarity in how the currents in these traces translate to magnetic fields. In some embodiments, there is a difference only at the fourth decimal in uT/mA (where uT indicates microtesla), even though the traces are disposed at different distances from the sensor location. This allows precise fault detection. For example, in a 3-phase system, it means that the superposition of magnetic field will be close to 0. In particular, in a balanced 3-phase system, the sum of the fields generated by the currents is null. However, each individual current is not 0. If the current-to-field conversion factors at the sensor location are substantially equal, then the superposition of the magnetic fields results in a null field. However, in case they are not substantially equal, then the field resulting from the superposition would not be always close to 0, and in fact may vary in time. An advantage that the conversions factors are substantially equal within a few percentage (e.g. under 5%), as provided in some embodiments of the present invention, is that a simple threshold on the signal can be used to determine whether there is fault or not at the output. Thus, the system may comprise a comparator with a simple configuration for detecting a fault.

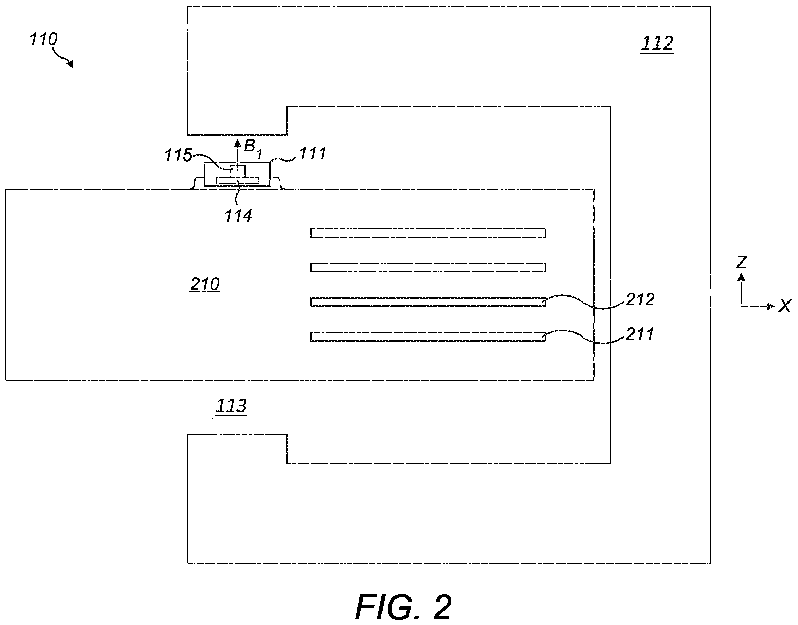

The following tables show the conversion factors for Hall elements sensitive to the component Bz as shown in FIG. 2 in different cores (a C-core and a so-called R core, shown in FIG 3). The conversion factors show very small differences for different layers with 2 loops. The results are obtained by simulation, by connecting the current to a source sequentially through each layer, while having the rest disconnected from the source. Although these results are obtained by simulation, they can also be provided by measurement.

**Table I - Conversion factor for a system of the present invention**

| N. loops | Current [mA] | Bz Hall with C-core | | Bz Hall with R-shield | |
|---|---|---|---|---|---|
| 2 | 30 | Signal uT/mA | Signal uT | Signal uT/mA | Signal uT |
| Layer 1 | | 0.15473 | 9.2838 | 0.35349 | 21.2094 |
| Layer 2 | | 0.1546 | 9.276 | 0.35331 | 21.1986 |
| Layer 3 | | 0.15448 | 9.2688 | 0.35314 | 21.1884 |
| Layer 4 | | 0.15436 | 9.2616 | 0.35298 | 21.1788 |
| Layer 5 | | 0.15425 | 9.255 | 0.35284 | 21.1704 |
| Average | | 0.154484 | 9.26904 | 0.353152 | 21.18912 |

The following Table II shows the conversion factor for a sensing system using Hall elements combined with IMCs.

**Table II - Conversion factor for a system with IMC**

| N. loops | Current [mA] | IMC-Hall with R-shield | |
|---|---|---|---|
| 2 | 30 | Signal uT/mA | Signal uT |
| Layer 1 | | 0.19274 | 11.5644 |
| Layer 2 | | 0.19255 | 11.553 |
| Layer 3 | | 0.19237 | 11.5422 |
| Layer 4 | | 0.19223 | 11.5338 |
| Layer 5 | | 0.19211 | 11.5266 |
| Average | | 0.1924 | 11.544 |

These results have been found for a so-called power PCB with a height between 3 mm and 5 mm, with four stacked traces. The traces of these PCBs may have a geometry such that each trace has a width between 10 mm and 50 mm, and a thickness of around 100 microns. For example, the thickness may be between 30 microns and 300 microns, or between 50 microns and 150 microns. The separation between the traces may be between 50 microns and 500 microns, or between 250 microns and 350 microns, for example it may be around 300 microns.

However, the present invention is not limited to these particular values, and they may have a predetermined width-to-thickness ratio. This term refers to the proportional relationship between the horizontal extent (width) of the conductive traces and their vertical dimension (thickness). A width-to-thickness ratio of at least 10 indicates that the width is at least ten times greater than the thickness. In embodiments of the present invention the width-to-thickness ratio is at least 10, for example at least 20, e.g. at least 50, e.g. at least 100. Examples of specific embodiments of traces with a high width-to-thickness ratio include flat, ribbon-like conductors or wide PCB traces with minimal thickness.

The yoke not only acts as a picking device for magnetic fields, but also serves as a shield against disturbances from external stray fields. For example, a few mT of stray-field along x will generate less than 100 mV at the output. Additional shielding can be added to reduce the influence. Cross talk influence is limited, for example a track carrying 30A at around 10 mm from the sensor generates a signal of 1.31mV. These errors can be reduced to a negligible influence, by compensation with a processor or microcontroller.

Although FIG 1 shows the sensing element being sensitive to a component of the magnetic field in one direction being parallel to the plane of the largest surface of the sensor substrate, this is not the only option. For example, the sensing element may be sensitive to a component being perpendicular.

FIG. 2 shows a different layout of the system 110. In particular the sensor 111 is inside the opening 113 of the yoke 112. The sensor is in this case sensitive to fields B₁ which traverse the sensor perpendicularly, for example for a packaged sensor, the field may traverse perpendicularly the largest surface of the package. Said perpendicular field follows the vertical direction Z, which is the direction of the width of the opening. Thus, the field crossing the opening is parallel to the direction to which the sensor is sensitive. In other words, the sensor is sensitive to the field component in the vertical direction which is the direction of the opening of the yoke.

The sensor, as before, may be placed on a substrate, which may be shared with the TCs. This means that the sensor, including the sensing element, can be mounted directly on the same substrate that contains the conductive traces acting as target conductors. Examples of specific embodiments of this configuration include integrated circuits or sensors that are attached to the surface of a PCB. In some embodiments, the sensor substrate (e.g. IC) including the sensing element may be directly fabricated on or embedded within the PCB including the traces.

The sensor may be connected on the outer surface of the substrate as before. In embodiments, the TCs may be traces which do not extend within the opening, so there is negligible leak of induced magnetic field. Thus, in this case the PCB extends from the inside of the yoke where the traces are provided, to and within the opening, where the sensor is provided, so in this case the sensor does not overlap the stack of traces.

As shown in the figure, the opening 103 in the yoke is situated to one side of the stack of conductive traces 211, 212. The PCB extends into and beyond the opening, with the sensor 111 and sensing element 115 mounted on the PCB portion within the opening 113. This configuration allows the sensor to detect the perpendicular component of the magnetic field, aligning with the axis of maximum sensitivity of the sensing element 115. Where the sensor is within the opening of the yoke, it is an advantage that the detected signal is high compared to other dispositions. The signal to noise ratio may also be higher.

In some alternative embodiments, the sensor is offset relative to the symmetry plane of the core, e.g. the sensor may be displaced relative to the center axis of the opening. In some embodiments, the plurality of TCs is disposed symmetrically relative to the symmetry plane of the core as shown in FIG. 2. Thus, in some embodiments, the TCs are substantially centered with respect to the core, but the sensor is not.

In some embodiments, the part of the yoke including the opening may be tapered to concentrate the field on or around the region where the sensor is placed. The tapering can be used whether the sensor is within the opening (as in FIG 2) or outside the opening and adjacent to it (as in FIG 1)

FIG. 3 shows a perspective view of two different embodiments of a yoke 122, 132 enclosing a substrate 220, 230 comprising a plurality of TCs. The TCs are stacked in both cases in the Z direction and the direction of the current through the TCs follows the direction Y.

In FIG. 3a, the yoke 122 is a C-core, which has faces parallel to the main directions X, Y, Z, including the faces of the opening. The opening width is smaller than 25% of the perimeter of the yoke.

The opening is placed at the side of the substrate 220, and if there is a non-zero superposition field, it would cross the opening following the vertical direction Z. The sensing element (partially shown at the opening) is situated at the opening, and it may be offset with the central axis of the opening. The sensing element may be connected to the substrate 220 as explained earlier (either integrated with the substrate 220, provided on a sensor substrate and packaged or encapsulated directly on the substrate, or provided as a separate sensor on a chip and connected to the substrate 220).

FIG. 3b shows an alternative yoke 132, namely an R-shield or R-core, with the opening width oriented in the X direction. The sensor and the TCs of the substrate 220 may be centered with the central axis of the core and of the opening. The side arms of the yoke around the opening are tapered in the plane perpendicular to the Z direction.

The opening is configured on top of the substrate, next to the sensing element (partially shown at the opening). The tapering of the yoke allows concentration of field across the opening in the horizontal X direction, so the superposition of the field in the yoke increases around the area where the sensor is placed, thus increasing signal and signal-to-noise ratio.

Alternatively, an R-core type of yoke 132 could be combined with a substrate 220 adapted to provide the sensing element within the opening of the yoke, and viceversa, thus combining the substrates and yokes of FIG. 3a and FIG. 3b as suitable as required for a particular application.

In some embodiments, the distance between the outer edge of the traces and the inner edge of the magnetic core can be between 0.5 mm and 10 mm, for example 0.5 mm and 5mm, for example 1 mm. This enables low losses in the collection of the superposition field within the magnetic material of the magnetic core.

In the further aspect of the invention, the current-sensing system includes a processing circuit configured to detect faults based on the superposition signal. The superposition field can be predetermined, and is used to detect a fault, such as a ground fault. In a 3-phase system, the superposition is checked not to exceed 0 by a predetermined value. The conversion factor from current to field for each trace at the sensor location is very close, even though the traces are disposed at different distances from the sensor location. The processing circuit may detect a fault when a field surpasses a threshold value, providing a straightforward method for fault detection. This system is designed to be tolerant of variations in sensor positioning and is capable of detecting faults with high sensitivity and accuracy, allowing for precise fault detection and accurate detection of a ground fault in e.g. a multiphase current.

Despite potential issues of heat dissipation in the substrate containing the PCBs due to the large currents that the TCs may carry, the system is thermally and mechanically robust due to the mechanical decoupling of the sensor and the magnetic core. The very high ratio of the traces may cause a good current-to-field factor.

## Claims

1. A current-sensing system (100, 110) for fault detection comprising a sensing element (105, 115) for detecting magnetic field, a magnetic core (102) with an opening (103), wherein the magnetic core is arranged for enclosing at least two target conductors (201, 202), the sensing element being configured for detecting a component of the superposition of the magnetic field generated through the opening by at least two currents carried by the respective target conductor, the sensing element being mechanically uncoupled from the magnetic core, the sensing element being further configured to provide an output signal indicative of the superposition of the magnetic field.

2. The system of claim 1 wherein the sensing element (105, 115) is at least 0.5 mm away from the magnetic core (102).

3. The system of any one of the previous claims further comprising a substrate (200, 210) comprising at least two target conductors being conductive traces.

4. The system of the previous claim wherein the width-to-thickness ratio of the traces is at least 10, for example at least 100.

5. The system of any one of claims 3 or 4 wherein the conductive traces are stacked on top of each other.

6. The system of the previous claim wherein a first trace is the stacked conductive trace located closest to the sensing element, wherein a second trace is the stacked conductive trace located in the stack so that the first trace is present between said second trace and the sensing element, wherein a first current-to-magnetic field conversion factor from the first trace is less than 5%, or less than 2%, or less than 1% different than a second current-to-magnetic field conversion factor from the second trace.

7. The system of any one of claims 3 to 6 wherein the sensing element is provided on a sensor on the substrate comprising the at least two target conductors.

8. The system of any one of claims 3 to 7 wherein at least one target conductor loops so that the current of said conductor is enclosed at least twice by the magnetic core.

9. The system of any one of claims 3 to 8 wherein the number of conductors (201, 202) is between 3 and 5.

10. The system of any one of the previous claims wherein the sensing element (105) is provided on a planar sensor substrate (104) comprising at least one largest dimension, wherein the at least one largest dimension of the sensor substrate is smaller than the width (w) of the opening.

11. The system of any one of the previous claims wherein the sensing element is sensitive to a component of the magnetic field in one direction.

12. The system of the previous claim wherein the sensing element (105) is provided on a sensor substrate (104) comprising at least one planar surface on a side, wherein the magnetic sensing element comprises an axis of maximum sensitivity parallel to the plane of the largest surface of the sensor substrate, wherein the opening is provided on the magnetic core such that the magnetic field across the opening is parallel to the axis of maximum sensitivity of the sensing element.

13. The system of claim 11 wherein the sensing element (115) is provided on a planar sensor substrate (114) comprising at least one largest surface, wherein the magnetic sensing element comprises an axis of maximum sensitivity perpendicular to the plane of the largest surface of the sensor substrate, wherein the opening is provided on the magnetic core such that the magnetic field across the opening is parallel to the axis of maximum sensitivity of the at least one sensing element.

14. The system of any one of the previous claims further comprising a processing circuit configured to detect fault based on the superposition signal.

15. The system of the previous claim wherein the processing circuit is configured to detect fault upon detection of a field surpassing a threshold value.
